# EUROPÄISCHE PATENTSCHRIFT

(11) **EP 0 524 213 B1**
(45) Veröffentlichungstag und Bekanntmachung des Hinweises auf die Patenterteilung: **14.09.1994**
(21) Anmeldenummer: 91907090.4
(22) Anmeldetag: 08.04.1991
(51) Int. Cl.: G02F 1/025, G02B 6/12, H01L 31/105

(54) **HALBLEITERELEMENT MIT EINER SCHWACH DOTIERTEN SILIZIUM-SCHICHT MIT EINER PIN-DIODENSTRUKTUR**
SEMICONDUCTOR COMPONENT WITH A SLIGHTLY DOPED SILICON LAYER WITH A PIN DIODE STRUCTURE
ELEMENT SEMICONDUCTEUR AVEC UNE COUCHE EN SILICIUM FAIBLEMENT DOPEE ET UNE STRUCTURE A DIODE P-I-N

(30) Priorität: 09.04.1990 DE 4011861
(43) Veröffentlichungstag der Anmeldung: 27.01.1993
(73) Patentinhaber: SIEMENS AKTIENGESELLSCHAFT, 80333 München (DE)
(72) Erfinder: SCHÜPPERT, Bernd, D-1000 Berlin 31 (DE); SPLETT, Armin, D-1000 Berlin 41 (DE); SCHMIDTCHEN, Joachim, D-1000 Berlin 20 (DE); PETERMANN, Klaus, D-1000 Berlin 27 (DE); SCHLAAK, Helmut, D-1000 Berlin 33 (DE)
(86) Internationale Anmeldenummer: DE9100302
(87) Internationale Veröffentlichungsnummer: WO9115797

(56) Entgegenhaltungen:
- US-A- 4 787 691
- IEEE Conference Record of the 1988 Eighteenth Power Modulator Symposium, New York, US, A. Rosen et al. : "Optically activated pin diode switch", pp. 223-226
- Electronics Letters, vol. 25, no. 22, 26 October 1989, Stevenage, Herts., GB, B. Schüppert et al. : "Optical channel waveguides in silicon diffused from GeSi alloy", pp. 1500-1502
- IEEE Electron Device Letters, vol. EDL-7, no. 5, May 1986, IEEE, New York, US, T.P. Pearsall et al. : "Avalanche gain in GexSi1-x/Si infrared waveguide detectors", pp. 330-332
- IEEE Transactions on Electron Devices, vol. ED-33, no. 2, February 1986, IEEE, New York, US, J.P. Colinge : "P-i-n photodiodes made in laser-recrystallized silicon-on-insulator", pp. 203-205

## Beschreibung

Die Erfindung bezieht sich auf ein Halbleiterelement, bestehend aus einer schwach dotierten Silizium-Schicht, die zwei Bereiche verschiedener Dotierung besitzt, leitfähigen Kontakten die mit den Bereichen verschiedener Dotierung verbunden sind, und einem optischen Wellenleiter der zwischen den Bereichen verschiedener Dotierung liegt, wobei die Bereiche verschiedener Dotierung zusammen mit dem um den optischen Wellenleiter gelegenen intrinsischen Bereich eine pin-Diodenstruktur bilden.

Ein bekanntes Halbleiterelement dieser Art (US-A-4 787 691) hat einen waffelartigen Aufbau mit zwei schichtförmigen Bereichen verschiedener Dotierung, die der Ober- und der Unterseite des Halbleiterelementes benachbart angeordnet sind; mit diesen schichtförmigen Bereichen sind äußere leitfähige Kontakte verbunden. Die schichtförmigen Bereiche bilden mit einer intrinsischen Schicht eine pin-Diodenstruktur, die zusätzlich einen optischen Wellenleiter enthält.

Ferner ist ein als Fotodiode ausgeführtes Halbleiterelement in dem Lehrbuch "Elektronik II Bauelemente" aus der HPI-Fachbuchreihe Elektronik, 3. Aufl., 1986, S. 405 beschrieben. Dieses bekannte Halbleiterelement hat einen waffelartigen Aufbau und enthält eine mittlere intrinsische Zone, einen oberhalb dieser intrinsischen Zone liegenden p-Bereich und einen unterhalb der intrinsischen Zone liegenden n-Bereich; sowohl am p-Bereich als auch am n-Bereich sind leitfähige Kontakte vorhanden, über die ein der Beleuchtungsstärke von auf das Halbleiterelement fallenden Licht entsprechender Fotostrom abnehmbar ist.

Der Erfindung liegt die Aufgabe zugrunde, ein Halbleiterelement mit einer schwach dotierten Silizium-Schicht mit einer pin-Diodenstruktur so fortzuentwickeln, daß ein mit geringen Verlusten arbeitender elektro-optischer Modulator entsteht.

Zur Lösung dieser Aufgabe gehen bei einem Halbleiterelement der eingangs angegebenen Art erfindungsgemäß die Bereiche verschiedener Dotierung von einer und derselben Seite der Silizium-Schicht aus, und es wird dadurch eine laterale pin-Diodenstruktur gebildet.

Es ist zwar aus der Zeitschrift "Appl. Phys. Lett. 51 (1), 6. July 1987, Seiten 6 bis 8 ein als elektro-optischer Modulator einsetzbarer elektro-optischer Schalter in Silizium-Technik bekannt, jedoch schließt bei diesem Schalter der optische Wellenleiter hochdotierte Bereiche ein, was zu hohen Verlusten aufgrund der Absorption freier Ladungsträger führt. Außerdem ist bei dem bekannten optischen Schalter die Metallisierung für die elektro-optische Ansteuerung unmittelbar am optischen Wellenleiter vorgesehen, wodurch weitere Verluste entstehen.

Das erfindungsgemäße Halbleiterelement hat unter anderem den Vorteil, daß aufgrund des lateralen Aufbaus der pin-Diodenstruktur mit im Abstand nebeneinander liegenden Bereiche mit verschiedener Dotierung hohe Verluste vermieden sind; der optische Wellenleiter ist dabei verhältnismäßig weit von den leitfähigen Kontakten entfernt. Im übrigen ist der optische Wellenleiter in schwach dotierten Bereichen geführt, was hinsichtlich der Vermeidung von Verlusten ebenfalls günstig ist.

Bei dem erfindungsgemäßen Halbleiterelement kann der Wellenleiter in unterschiedlicher Weise gebildet sein. Als vorteilhaft wird es angesehen, wenn der optische Wellenleiter in der intrinsischen Zone durch Eindiffundieren eines Stoffes mit einem Element der Gruppe IV des Periodensystems mit einem höheren Realteil der Brechzahl als der des Siliziums in die Silizium-Schicht gebildet ist, wie es im einzelnen in der älteren deutschen Patentanmeldung P 39 22 009.5 (GR 89 P 8552 DE) beschrieben ist. Bei dieser Ausführungsform des erfindungsgemäßen Halbleiterelementes wird eine übermäßige Absorption durch freie Ladungsträger vermieden.

Als Stoff mit einem Element der Gruppe IV des Periodensystems kann mit Vorteil ein Germanium enthaltender Stoff benutzt werden; als besonders vorteilhaft ist die Verwendung einer GeₓSi₍₁₋ₓ₎-Legierung.

Als vorteilhaft wird es ferner angesehen, wenn bei einer anderen Ausführungsform des erfindungsgemäßen Halbleiterelementes die Silizium-Schicht eine Germanium-Silizium-Mischkristallschicht trägt, die mit einer Rippe den optischen Wellenleiter bildet. Die Bildung der Rippe kann dabei in bekannter Weise erfolgen.

Bei einer weiteren vorteilhaften Ausführungsform des erfindungsgemäßen Halbleiterelementes ist die Silizium-Schicht eine epitaktische Silizium-Schicht auf einem Silizium-Substrat, und zwischen der Silizium-Schicht und dem Silizium-Substrat befindet sich eine isolierende Schicht; eine Rippe der epitaktischen Silizium-Schicht bildet den optischen Wellenleiter.

Bei den bisher beschriebenen Ausführungsformen des erfindungsgemäßen Halbleiterelementes erfolgt durch die Injektion von Ladungsträgern in den optischen Wellenleiter eine Modulation der optischen Phase. Um die Phasenmodulation in eine Intensitätsmodulation umzusetzen, ist das erfindungsgemäße Halbleiterelement in vorteilhafter Weise Bestandteil eines Mach-Zehnder-Interferometers, indem es einen Zweig eines solchen Interferometers bildet.

Zur Erläuterung der Erfindung ist in
Fig. 1 eine perspektivische Darstellung eines durchgeschnittenen Ausführungsbeispiels des erfindungsgemäßen Halbleiterelementes mit einer pin-Diodenstruktur in einer schwach dotierten Silizium-Schicht, in
Fig. 2 ein Querschnitt durch ein weiteres Ausführungsbeispiel des erfindungsgemäßen Halbleiterelementes mit einem von einer Rippe einer Germanium-Silizium-Schicht gebildeten optischen Wellenleiter, in
Fig. 3 ein Querschnitt durch ein zusätzliches Ausführungsbeispiel mit einem von einer Rippe einer schwach dotierten Silizium-Schicht gebildeten Wellenleiter und in
Fig. 4 eine perspektivische Ansicht eines in ein Mach-Zehnder-Interferometer integrierten Halbleiterelements gemäß der Erfindung dargestellt.

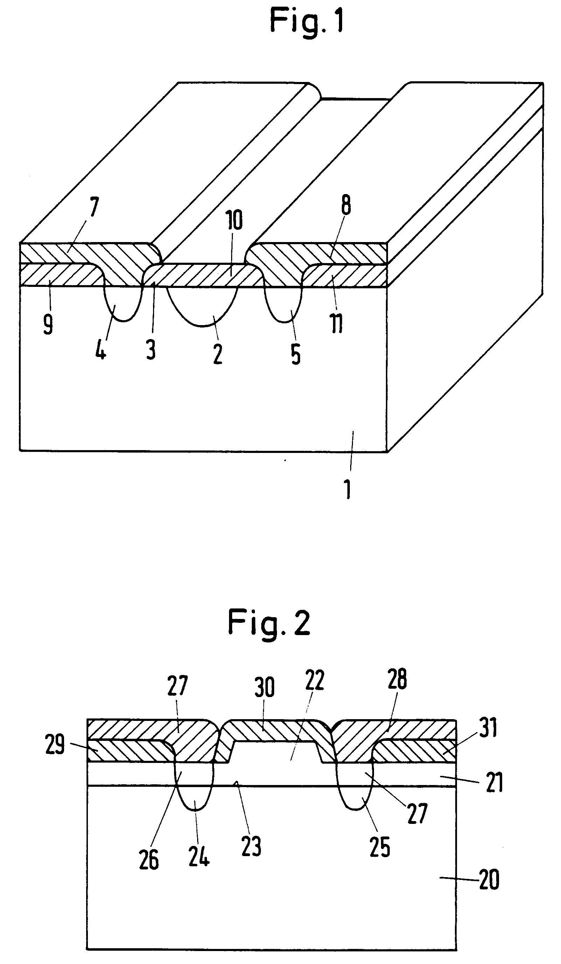

Bei dem Ausführungsbeispiel nach Fig. 1 ist eine schwach dotierte Silizium-Schicht 1 vorgesehen, die einen optischen Wellenleiter 2 im Bereich ihrer Oberseite 3 besitzt; der optische Wellenleiter 2 ist durch Eindiffundieren eines Streifens aus einem Stoff mit einem Element der Gruppe IV des Periodensystems mit einem höheren Realteil der Brechzahl als der des Siliziums in die Silizium-Schicht 1 gebildet, wie dies im einzelnen in der bereits erwähnten älteren deutschen Patentanmeldung P 39 22 009.5 beschrieben ist. Beiderseits des optischen Wellenleiters 2 befinden sich Bereiche 4 und 5, die eine unterschiedliche Dotierung aufweisen. So handelt es sich bei dem Bereich 4 um einen p⁺-Bereich, während der Bereich 5 einen n⁺-Bereich darstellt. Beide Bereiche 4 und 5 gehen von derselben Seite 3 der Silizium-Schicht 1 aus und bilden somit zusammen mit der intrinsischen Schicht um den optischen Wellenleiter 2 eine laterale pin-Diodenstruktur.

Beide Bereiche 4 und 5 sind kontaktiert von leitfähigen Kontakten 7 und 8, die im Gebiet außerhalb des p⁺-Bereichs 4 und n⁺-Bereichs 5 von der schwach dotierten Silizium-Schicht 1 mittels Isolierschichten 9, 10 und 11 isoliert sind, die aus Siliziumdioxid oder Siliziumnitrid bestehen. Wie die Fig. 1 zeigt, sind sowohl die Isolierschichten 9, 10 und 11 wie auch die leitfähigen Kontakte 7 und 8 streifenförmig ausgebildet, und die Bereiche 4 und 5 wie auch der optische Wellenleiter 2 erstrecken sich parallel dazu.

An die leitfähigen Kontakte 7 und 8 ist in nicht dargestellter Weise eine elektrische Spannung in Flußrichtung anzulegen. Die dadurch hervorgerufene Injektion von Ladungsträgern in den optischen Wellenleiter 2 führt zu einer Änderung der Brechzahl, wodurch eine Modulation der optischen Phase des den optischen Wellenleiter 2 durchsetzten Lichtes eintritt. Damit ist in Abhängigkeit von der angelegten elektrischen Spannung eine Phasenmodulation des Lichtes im Wellenleiter 2 möglich.

Bei dem Ausführungsbeispiel nach Fig. 2 ist auf eine schwach dotierte Silizium-Schicht 20 eine Germanium-Silizium-Schicht 21 aufgebracht, aus der durch Ätzen in bekannter Weise ein rippenförmiger optischer Wellenleiter 22 gebildet ist. Beiderseits des optischen Wellenleiters 22 und wiederum von einer Oberseite 23 ausgehend ist ein p⁺-Bereich 24 sowie ein n⁺-Bereich 25 gebildet; beide Bereiche 24 und 25 stellen zusammen mit der zwischen ihnen liegenden intrinsischen Zone eine pin-Diodenstruktur, die über in gleicher Weise dotierte Übergangsbereiche 26 und 27 in der Germanium-Silizium-Schicht 21 mit leitfähigen Kontakten 27 und 28 verbunden ist.

In ähnlicher Weise wie im Zusammenhang mit der Fig. 1 beschrieben, dienen zur Isolation Schichten 29, 30 und 31.

Im übrigen läßt sich auch bei dem Halbleiterelement gemäß Fig. 2 durch Anlegen einer Spannung an die leitfähigen Kontakten 27 und 28 in Flußrichtung eine Phasenmodulation des Lichtes im optischen Wellenleiter 22 erzielen, wie es im Zusammenhang mit der Fig. 1 bereits näher erläutert worden ist.

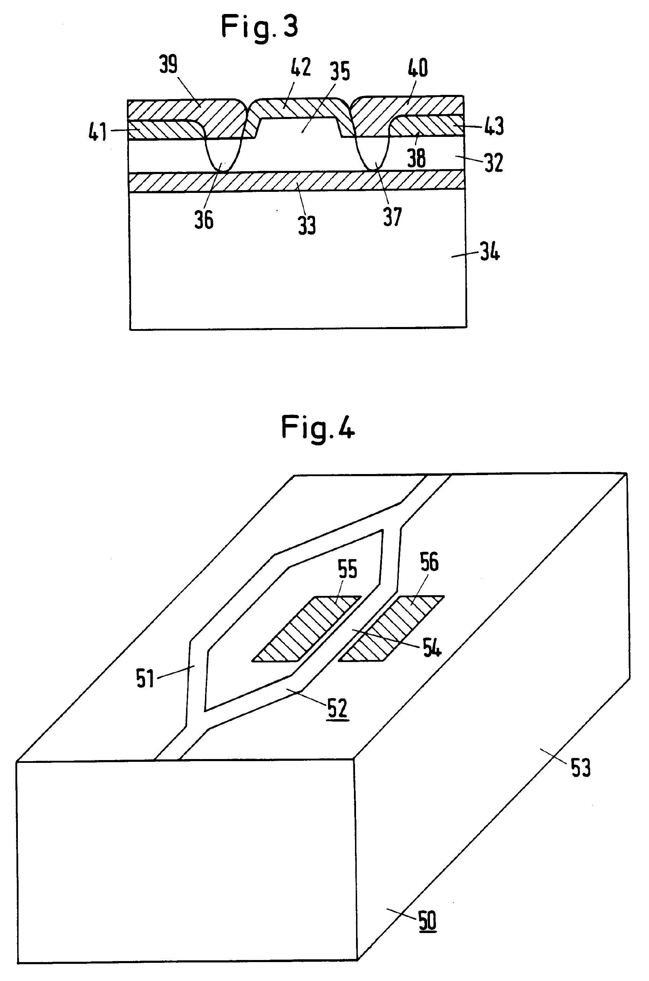

Das Ausführungsbeispiel nach Fig. 3 weist eine schwach dotierte Silizium-Schicht 32 auf, die über eine Isolierschicht 33 von einem beliebig dotierten Substrat 34 getragen ist. Ein optischer Wellenleiter 35 ist bei diesem Ausführungsbeispiel von einer Rippe der schwach dotierten Silizium-Schicht 32 gebildet. Beiderseits des Wellenleites 35 sind auch hier ein p⁺-Bereich 36 und ein n⁺-Bereich 37 von einer Oberseite 38 der Silizium-Schicht 32 ausgehend gebildet, so daß wiederum durch die Bereiche 36 und 37 mit der zwischen ihnen liegenden intrinsischen Zone der Silizium-Schicht 32 eine pin-Diodenstruktur gebildet ist.

Wie bereits im Zusammenhang mit der Fig. 1 beschrieben, sind die Bereiche 36 und 37 mit leitfähigen Kontakten 39 und 40 galvanisch verbunden, wobei wiederum Isolierschichten 41, 42 und 43 zur elektrischen Isolation dienen.

In Fig. 4 ist ein Mach-Zehnder-Interferometer 50 in Halbleitertechnik mit seinen beiden optischen Zweigen 51 und 52 gezeigt, die durch jeweils einen optischen Wellenleiter gebildet sind. Die optischen Wellenleiter sind als Rippen auf einer Silizium-Schicht 53 schwacher Dotierung aufgebracht. Beiderseits des mittleren Bereichs 54 des Wellenleiters der optischen Verzweigung 52 liegen leitfähige Kontakte 55 und 56, die den leitfähigen Kontakten nach den Fig. 1 bis 3 entsprechen. Unterhalb der leitfähigen Kontakte 55 und 56 und daher in Fig. 4 nicht erkennbar, ist die pin-Diodenstruktur entsprechend den voran gegangenen Ausführungsbeispielen gebildet.

Mit dem Ausführungsbeispiel nach Fig. 4 ist es möglich, die in dem einen optischen Zweig 52 im Bereich des optischen Wellenleiters 54 erfolgende Phasenmodulation des Lichtes in eine Intensitätsmodulation durch Interferenz umzusetzen.

## Patentansprüche

1. Halbleiterelement, bestehend aus
einer schwach dotierten Silizium-Schicht (1;20;32), die zwei Bereiche (4,5;24,25;36,37) verschiedener Dotierung besitzt,
leitfähigen Kontakten (7,8;27,28;39,40), die mit den Bereichen verschiedener Dotierung verbunden sind, und
einem optischen Wellenleiter (2;22;35), der zwischen den Bereichen verschiedener Dotierung liegt, wobei die Bereiche verschiedener Dotierung zusammen mit dem um den optischen Wellenleiter gelegenen intrinsischen Bereich eine pin-Diodenstruktur bilden,
**dadurch gekennzeichnet**, daß
die Bereiche (4,5;24,25;36,37) verschiedener Dotierung von einer und derselben Seite (3;23) der Silizium-Schicht ausgehen und dadurch eine laterale pin-Diodenstruktur gebildet wird.

2. Halbleiterelement nach Anspruch 1,
**dadurch gekennzeichnet**,
daß der optische Wellenleiter (2) in der intrinsischen Zone durch Eindiffundieren eines Stoffes mit einem Element der Gruppe IV des Periodensystems mit einem höheren Realteil der Brechzahl als der des Siliziums in die Silizium-Schicht (1) gebildet ist.

3. Halbleiterelement nach Anspruch 2,
**dadurch gekennzeichnet**, daß
der Stoff Germanium enthält.

4. Halbleiterelement nach Anspruch 2 oder 3,
**dadurch gekennzeichnet**,
daß der Stoff eine GeₓSi₍₁₋ₓ₎-Legierung ist.

5. Halbleiterlement nach Anspruch 1,
**dadurch gekennzeichnet**,
daß die Silizium-Schicht (20) eine Germanium-Silizium-Mischkristallschicht (21) trägt, die mit einer Rippe den optischen Wellenleiter (22) bildet.

6. Halbleiterelement nach Anspruch 1,
**dadurch gekennzeichnet**, daß
die Silizium-Schicht eine epitaktische Silizium-Schicht (32) auf einem Silizium-Substrat (34) ist,
daß sich zwischen der Silizium-Schicht (32) und dem Silizium-Substrat (34) eine isolierende Schicht (23) befindet und daß eine Rippe der epitaktischen Silizium-Schicht (32) den optischen Wellenleiter (35) bildet.

7. Halbleiterelement nach einem der vorangehenden Ansprüche,
**dadurch gekennzeichnet**,
daß es Bestandteil eines Mach-Zehnder-Interferometers (50) ist, indem es einen Zweig (52) eines solchen Interferometers bildet.

## Claims

1. Semiconductor element, consisting of a weakly doped silicon layer (1; 20; 32), which has two areas (4,5; 24,25; 36,37) of different doping, conductive contacts (7,8; 27,28; 39,40), which are connected to the areas of different doping, and an optical waveguide (2; 22; 35), which lies between the areas of different doping, the areas of different doping together with the intrinsic area around the optical waveguide forming a p-i-n diode structure, characterized in that the areas (4,5; 24,25; 36,37) of different doping issue from one and the same side (3; 23) of the silicon layer and a lateral p-i-n diode structure is formed thereby.

2. Semiconductor element according to claim 1, characterized in that the optical waveguide (2) in the intrinsic zone is formed by diffusing a material containing an element of Group IV of the periodic system with a higher real component of the refractive index than that of silicon into the silicon layer (1).

3. Semiconductor element according to claim 2, characterized in that the material contains germanium.

4. Semiconductor element according to claim 2 or 3, characterized in that the material is a GeₓSi₍₁₋ₓ₎ alloy.

5. Semiconductor element according to claim 1, characterized in that the silicon layer (20) carries a germanium-silicon mixed crystal layer (21), which with a rib forms the optical waveguide (22).

6. Semiconductor element according to claim 1, characterized in that the silicon layer is an epitaxial silicon layer (32) on a silicon substrate (34), that located between the silicon layer (32) and the silicon substrate (34) is an insulating layer (23) and that a rib of the epitaxial silicon layer (32) forms the optical waveguide (35).

7. Semiconductor element according to any one of the preceding claims, characterized in that it is a component part of a Mach-Zehnder interferometer (50), forming a branch (52) of such an interferometer.

## Revendications

1. Élément semiconducteur, constitué par
d'une couche de silicium (1;20;32) faiblement dopée, qui possède deux régions (4,5; 24,25; 36,37) ayant des dopages différents,
de contacts conducteurs (7,8; 27,28; 39,40), qui sont reliés aux régions ayant des dopages différents, et
d'un guide d'ondes optiques (2;22;35), qui est entre les régions possédant des dopages différents, ces régions ayant des dopages différents formant, conjointement avec la région intrinsèque disposée autour du guide d'ondes optiques, une structure de diode pin,
caractérisé par le fait que les régions (4,5; 24,25; 36,37) ayant des dopages différents s'étendent d'un seul et même côté (3;23) de la couche de silicium et qu'il est ainsi formé une structure de diode pin latérale.

2. Élément semiconducteur suivant la revendication 1, caractérisé par le fait que le guide d'ondes optiques (2) est formé dans la zone intrinsèque par diffusion d'une substance ayant un élément du groupe IV de la classification périodique des éléments, dont la partie réelle de l'indice de réfraction est supérieure à celle du silicium dans la couche de silicium (1).

3. Élément semiconducteur suivant la revendication 2, caractérisé par le fait que la substance contient du germanium.

4. Élément semiconducteur suivant la revendication 2 ou 3, caractérisé par le fait que la substance est un alliage de GeₓSi₍₁₋ₓ₎.

5. Élément semiconducteur suivant la revendication 1, caractérisé par le fait que la couche de silicium (20) porte une couche de cristal mixte de germanium-silicium (21), qui forme, avec une nervure, le guide d'ondes optiques (22).

6. Élément semiconducteur suivant la revendication 1, caractérisé par le fait que la couche de silicium est une couche de silicium (32) épitaxiale se trouvant sur un substrat en silicium (34), qu'une couche isolante (23) est interposée entre la couche de silicium (32) et le substrat en silicium (34), et qu'une nervure de la couche de silicium (32) épitaxiale forme le guide d'ondes optiques (35).

7. Élément semiconducteur suivant l'une des revendications précédentes, caractérisé par le fait qu'il fait partie d'un interféromètre de Mach-Zehnder (50), en formant une branche (52) d'un tel interféromètre.
